(19) Europäisches Patentamt
European Patent Office
Office européen des brevets

(11) Publication number: 0 113 034 B1

# (12) EUROPEAN PATENT SPECIFICATION

(45) Date of publication of patent specification: 09.09.87

(51) Int. Cl.$^4$: **G 03 F 7/10**, G 03 F 7/02

(21) Application number: 83111768.4

(22) Date of filing: 24.11.83

## (54) A method for producing a resist image involving the use of polystyrene-tetrathiafulvalene polymer as a deep-ultraviolet printing mask.

(30) Priority: 30.12.82 US 454811

(43) Date of publication of application: 11.07.84 Bulletin 84/28

(45) Publication of the grant of the patent: 09.09.87 Bulletin 87/37

(84) Designated Contracting States: DE FR GB

(56) References cited:
EP-A-0 002 999
EP-A-0 027 180

(73) Proprietor: International Business Machines Corporation
Old Orchard Road
Armonk, N.Y. 10504 (US)

(72) Inventor: Chao, Vivian Wei-Wen
3081 Radcliffe Drive
Yorktown Heights NY 10598 (US)
Inventor: Kaufman, Frank Benjamin
Bedell Road, Box 6
Amawalk New York 10501 (US)
Inventor: Kramer, Steven Robert
House 48-Croton Park Colony
Peekskill New York 10566 (US)
Inventor: Lin, Burn Jeng
15 Dickel Road
Scarsdale New York 10583 (US)

(74) Representative: Hobbs, Francis John
IBM United Kingdom Limited
Intellectual Property Department
Hursley Park Winchester
Hampshire SO21 2JN (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 113 034 B1

**Description**

This invention relates to a method for producing a resist image involving the use of polystyrene-tetrathiafulvalene polymer as a deep-ultraviolet printing mask.

In the manufacture of microelectronic devices and circuits, various fabrication techniques are used. One is a conformable masking technique as described by H. I. Smith, Rev. Sci. Instr., Vol. 40, p. 729, (1969). In this technique, a mask closely conforms to the surface topography of the substrate to be processed. This allows the mask and the wafer to be intimately contacted. As with other proximity printing techniques, very little hardware change is required to reduce the printing wavelengths to the deep-UV region (200—300 nm), so that minimum feature size and the height-to-width aspect ratio can be improved. Polychromatic exposure can be used to reduce standing waves and other interference effects as well as exposure times. Different types of resist profiles can also be produced with this technique.

However, the conformable printing technique is inherently susceptible to mask and wafer damage due to foreign particles. When the contact between the mask and the wafers is not perfect, the fringes created by any uneven mask-to-wafer gap can contribute to an uneven exposure distribution and will in turn produce uneven linewidth distributions. Because the wafer and the mask have to be safely separated during alignment, simultaneously viewing both the alignment marks on the mask and the wafer becomes a problem when a high numerical aperture alignment microscope is used to achieve high accuracy. Even after the mask and the wafer are perfectly aligned at the alignment separation, the alignment accuracy will be lost due to residual lateral movements caused by the vertical motion to bring the mask and the wafer closer for exposure.

Near-UV optical projection printing can be defect-free but cannot achieve a high aspect ratio in the photoresist image. Also, the achievable image height for projection printing systems is smaller than that for proximity printing, because a large part of the depth-of-field in the microfabrication projection lens is wasted in keeping the wafer in focus. Thus, while optical projection and electron beam systems inherently offer a freedom from defects and a high alignment accuracy, they both suffer from low aspect ratios in the resist image caused by focus tolerance and electron scattering, respectively.

In order to combine the advantages of projection systems with the advantages (high aspect ratio and profile-manipulating capabilities) of deep-UV conformable printing, a technique termed portable-conformable-mask technique (PCM) has been developed. This technique uses multiple resist layers, where a thin resist layer is spun on top of a thick deep-UV resist layer. The thin resist on top is chosen to be opaque for deep-UV light. It is first delineated by an optical projection or an electron beam mask aligner, and then serves as a perfect conformable mask for the bottom deep-UV resist, which can now be delineated with a blanket deep-UV exposure. The mask-wafer combination can be carried away from the mask aligner, and hence is termed "portable". The mask is no longer built on a transparent substrate as conventional masks are built. Therefore, despite the lack of suitable substrates, the blanket exposure of the PCM system can be extended to much shorter wavelengths as well. Such PCM systems are described by B. J. Lin in SPIE, Vol. 174, Developments in Semiconductor Microlithography IV, p. 114 (1979); B. J. Lin, et al J. Vac. Sci. Technol., Vol. 19, No. 4, p. 1313, Nov./Dec. 1981; B. J. Lin, et al J. Vac. Sci. Technol., Vol. 16, p. 1669 (1979); and U.S. Patent 4,211,834.

As pointed out in these articles, the well known Novalac Resist System (such as AZ1350) has been used as a deep-UV portable conformable mask for polymethyl methacrylate (PMMA) in a double-layer resist system for optical and electron beam exposures. For this system, both the top and bottom resist layers are positive. Residual exposure of the bottom layer during electron beam imaging of the top layer is acceptable. However, when a negative resist is used for the top layer, the residual exposure will reduce the contrast of the bottom layer.

This invention seeks to provide a negative PCM system which is tolerant to the problem of residual exposure.

Recently, as disclosed in EP—A—0027180, a new class of E-beam, x-ray and photoresist materials based upon electroactive polymers and a halocarbon have been developed. Reference is also made to D. Hofer and F. B. Kaufman, Appl. Phys. Lett., Vol. 37, p. 314, (1980). The electroactive polymer consists of a homopolymer or copolymer having a pi donor molecule bonded thereto through functional groups or side chains having functional groups capable of reacting with the functional groups of the donor molecule. Examples of such electroactive polymers are polystyrene, chloromethylated styrene, polyglutamic acid, polyvinyl chloride, polyepichlorohydrin, poly(alpha halo-phosphazene), and poly(acrylic chloride). Examples of pi donor molecules are fulvalenes within the general formula:

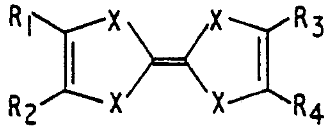

wherein X is oxygen, sulfur, selenium, tellurium or any combination thereof and each of $R_1$, $R_2$, $R_3$ and $R_4$ is an organic substituent. Specific fulvalene pi donors include tetrathiafulvalene (TTF), its derivatives and Se analogs (TSeF) and its derivatives such as tetrathiafulvalenecarboxylic acid ($TTFCO_2H$),

tetraselenafulvalenecarboxylic acid ($TSFCO_2H$), (hydroxymethyl)-tetrathiafulvalene ($TTFCH_2OH$), hydroxymethyl-tetraselenafulvalene ($TSeFCH_2OH$), (p-hydroxyphenyl)-tetrathiafulvalene ($TTFC_6H_4OH$), (p-hydroxyphenyl)-tetraselenafulvalene ($TSeFC_6H_4OH$), (p-aminophenyl)-tetrathiafulvalene ($TTFC_6H_4NH_2$), (p-carboxyphenyl)-tetrathiafulvalene ($TTFC_6H_4CO_2H$) and phenoxy-tetrathiafulvalene (PTTF).

Example 1 in EP—A—27180 is particularly concerned with electroactive polystyrene tetrathiafulvalene (PSTTF) resists.

According to the invention, a method for producing a resist image comprises the successive steps of:

(a) coating a substrate with a deep-ultraviolet sensitive polymer;

(b) coating said deep-ultraviolet sensitive polymer with a layer of a negative photoresist consisting of a halocarbon-doped electroactive polystyrene-tetrathiafulvalene polymer having the repeating unit:

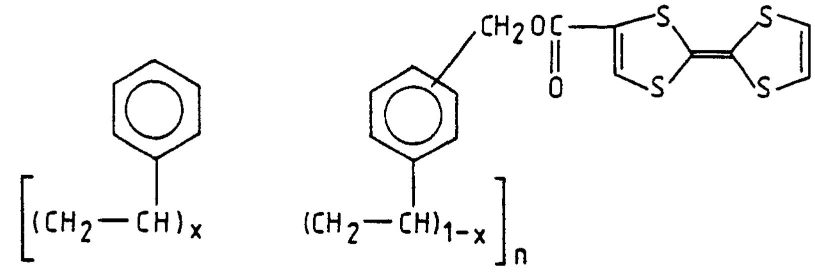

wherein the value of X is $0 \leq X < 1$ and n is from about 50 to about 10,000.

(c) pattern exposing the layer of negative photoresist with E-beam or x-ray radiation;

(d) developing the negative photoresist to reveal portions of the underlying deep-ultraviolet sensitive polymer;

(e) exposing revealed portions of the underlying deep-ultraviolet sensitive polymer with deep-ultraviolet radiation; and

(f) developing the exposed portions of the deep-ultraviolet sensitive polymer with a preferential solvent.

The PSTTF polymer employed in the aforedefined method provides an excellent negative resist material giving high resolution and sensitivity. For example, features smaller than 200 nm employing an E-beam dosage of 10 $\mu C/cm^2$ or x-ray energy of 50 $mJ/cm^2$ can be readily and conveniently obtained. The method of this invention is especially useful for providing a patterned PSTTF coating on a deep-UV mask substrate used in deep-ultraviolet proximity printing or projection printing mask. The method can also be advantageously practised to provide a combination of PSTTF with a deep-ultraviolet resist to form a portable conformable mask.

How the invention can be carried out will now be described. Any of the known deep-ultraviolet sensitive polymers, e.g., polymethyl methacrylate, the alpha olefin-sulfur dioxide-cyclopentene/bicycloheptene/methyl methacrylate terpolymer of US—A—3,898,350, polymethyl isopropyl ketone, etc., can be employed, typically on electronics grade silica as the substrate although, of course, other substrate materials are contemplated as well. The deep-ultraviolet sensitive polymer can be applied to the substrate in any number of ways with spinning from a solution of the polymer, for example, an 8—10% by weight solution of a polymethyl methacrylate of about 400,000 average molecular weight in chlorobenzene, onto the surface of the substrate followed by heat treatment to accelerate evaporation of the solvent being an especially advantageous technique. The thickness of this polymer layer can vary widely, with thicknesses of from about 0.2 μm to about 10 μm, and preferably from about 0.5 μm to about 3 μm generally providing good results. The polymer can be applied to the desired thickness in a single application or can be built up from a series of successive applications.

Following application and drying of the deep-UV sensitive layer, an organic solvent solution of polystyrene-tetrathiafulvalene (PSTTF) containing a halocarbon acceptor is applied to it, advantageously by means of the spin casting technique, to provide a layer ranging in thickness of from about 0.1 μm to about 2 μm, and preferably from about 0.2 μm to about 0.5 μm. Suitable solvents for the PSTTF include toluene, chloroform, methylene chloride, cyclopentanone, tetrahydrofuran and methyl ethyl ketone. The concentration of PSTTF in the solvent can vary widely, with 8—10% by weight solutions being generally suitable. Typical halocarbon acceptors which can be used are $CCl_4$, $CBr_4$, $CI_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$, $CHCl_3$, $CH_2Cl_2$, and the like, present in an amount ranging from about 0.01 to about 10 times the concentration of the donor moiety. The halocarbon acceptor makes the PSTTF film sensitive to radiation, such that upon exposure to E-beam or x-ray radiation, generally carried out in a vacuum, only the unexposed areas of the polymer can be removed from the underlying deep-ultraviolet sensitive polymer by washing or spraying, i.e., developing, with a selective non-polar solvent such as any of the solvents from which the PSTTF was originally applied.

When E-beam radiation is employed (scanning or blanket exposure), the charge density can advantageously be in the range of from about $1 \times 10^{-6}$ $C/cm^2$ to about $50 \times 10^{-6}$ $C/cm^2$ and preferably from about $2 \times 10^{-6}$ $C/cm^2$ to about $30 \times 10^{-6}$ $C/cm^2$. When x-ray radiation is employed, a dose of from about 10

$mJ/cm^2$ to about 100 $mJ/cm^2$, and preferably from about 25 $mJ/cm^2$ to about 65 $mJ/cm^2$, can be used with good results.

Following removal of the unexposed portions of the PSTTF layer, the underlying areas of the deep-UV sensitive polymer are blanket exposed with deep-UV radiation (from about 200 to about 260 nm wavelength), advantageously at a charge density of from about 100 $mJ/cm^2$ to about 2000 $mJ/cm^2$, and preferably from about 500 $mJ/cm^2$ to about 1000 $mJ/cm^2$. The exposed portions of the polymer are thereafter removed with a selective solvent therefor, e.g., methyl isobutyl ketone, to provide the negative resist image.

If desired, the PSTTF mask can be recycled, e.g., employing known oxygen plasma cleaning techniques. Other additive or subtractive operations such as metallization can also be carried out employing procedures which are well known in the art.

The following example is further illustrative of the method of the invention:

Example

A silicon dioxide wafer was coated to a total thickness of 2.4 μm with a polymethyl methacrylate (PMMA) of 500,000 average molecular weight. The PMMA was applied by spin coating at 1,000 rpm from a 10% by weight solution of the polymer in 2-methoxyethyl ether (diglyme) to provide an initial 1.2 μm layer upon drying. Following baking at 85°C for 20 minutes, another 1.2 μm thickness (upon drying) of the PMMA was applied followed by baking at 160°C for 1 hour.

A polystyrene-tetrathiafulvalene (PSTTF) layer of 0.6 μm thickness (upon drying) was applied to the PMMA layer by spin coating at 2,500 rpm from a 20 μl cyclopentanone solution of 4.7 mg PSTTF and 1 mg $C_2Br_2Cl_4$ as the halocarbon acceptor. Following evaporation of the cyclopentanone (without baking), the PSTTF was exposed to scanning E-beam radiation for a charge density of about 10 μ $C/cm^2$. Comparable results can be achieved employing x-ray radiation for a dosage level of 50 $mJ/cm^2$.

Following removal of the exposed regions of the PSTTF with tetrahydrofuran, the underlying portions of the PMMA layer were blanket exposed with 800 $mJ/cm^2$ of deep-ultraviolet radiation (200—260 nm wavelength) and the exposed PMMA was removed with methyl isobutyl ketone to provide the negative resist image.

Additional operations, optional in nature, included ashing in a forming gas plasma in a barrel reactor at 200 watts and 17.3 Pascals (0.13 Torr) for 10 minutes followed by evaporation of 0.8 μm aluminum and lift-off of the aluminum in trichloroethylene.

**Claims**

1. A method for producing a resist image comprising the successive steps of:

(a) coating a substrate with a deep-ultraviolet sensitive polymer;

(b) coating said deep-ultraviolet sensitive polymer with a layer of a negative photoresist consisting of a halocarbon-doped electroactive polystyrene-tetrathiafulvalene polymer having the repeating unit;

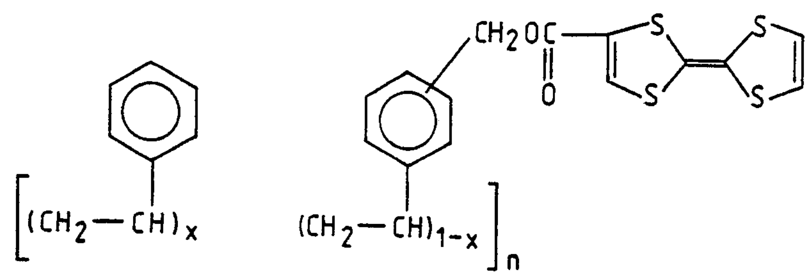

wherein the value of X is $0 \leq X < 1$ and n is from about 50 to about 10,000.

(c) pattern exposing the layer of negative photoresist with E-beam or x-ray radiation;

(d) developing the negative photoresist to reveal portions of the underlying deep-ultraviolet sensitive polymer;

(e) exposing said revealed portions of the underlying deep-ultraviolet sensitive polymer with deep-ultraviolet radiation; and

(f) developing the exposed portions of the deep-ultraviolet sensitive polymer with a preferential solvent.

2. A method as claimed in Claim 1, wherein the halocarbon in the negative photoresist is selected from the group consisting of $CCl_4$, $CBr_4$, $Cl_4$, $C_2Cl_6$, $C_2Cl_2Br_2$, $C_3Br_4H_4$, $C_2Br_2Cl_4$, $C_2H_2Cl_4$, $C_2Br_6$, $C_3Cl_8$, $CHBr_3$ and $CH_2Cl_2$.

3. A method as claimed in Claim 2, wherein the halocarbon is present at a level of from 0.01 to 10 times the concentration of the tetrathiafulvalene moiety of the electroactive polymer.

4. A method as claimed in any preceding claim, wherein n in said electroactive polymer has an average value of about 100.

5. A method as claimed in any preceding claim, wherein the deep-UV sensitive polymer is applied to a total thickness of from about 0.2 μm to about 10 μm.

6. A method as claimed in Claim 5, wherein the deep-UV sensitive polymer is applied to a total thickness of from about 0.5 μm to about 3 μm.

7. A method as claimed in any preceding claim, wherein the deep-UV sensitive layer is of an alkyl methacrylate polymer.

8. A method as claimed in Claim 7, wherein the alkyl methacrylate polymer is a polymethyl methacrylate.

9. A method as claimed in Claim 8, wherein the polymethyl methacrylate possesses an average molecular weight of from about 30,000 to about 2,000,000.

10. A method as claimed in Claim 8 or Claim 9, wherein the polymethyl methacrylate layer is applied by spin coating from a solution of 2-methoxyethyl ether.

11. A method as claimed in any preceding claim, wherein the negative photoresist layer is exposed to E-beam radiation for a charge density in the range of from about $1 \times 10^{-6}$ C/cm$^2$ to about $50 \times 10^{-6}$ C/cm$^2$.

12. A method as claimed in any of claims 1 to 10, wherein the negative photoresist layer is exposed to x-ray radiation for a dose of from about 10 mJ/cm$^2$ to about 100 mJ/cm$^2$.

13. A method as claimed in any preceding claim, wherein the deep-UV sensitive polymer is exposed to deep-UV radiation at a charge density of from about 100 mJ/cm$^2$ to about 2000 mJ/cm$^2$.

14. A method as claimed in any preceding claim, wherein the negative photoresist layer is developed with tetrahydrofuran or cyclopentanone.

**Patentansprüche**

1. Verfahren zur Herstellung eines Resist-Bildes mit den aufeinanderfolgenden Verfahrensschritten des

(a) Beschichtens eines Substrats mit einem auf fernes Ultraviolett empfindlichen Polymer;

(b) Beschichtens des auf fernes Ultraviolett empfindlichen Polymers mit einer Schicht aus einem negativen Photoresist, welcher aus einem mit halogensubstituiertem Kohlenwasserstoff dotierten elektroaktiven Polystyroltetrathiafulvalen-Polymer mit der Grundeinheit

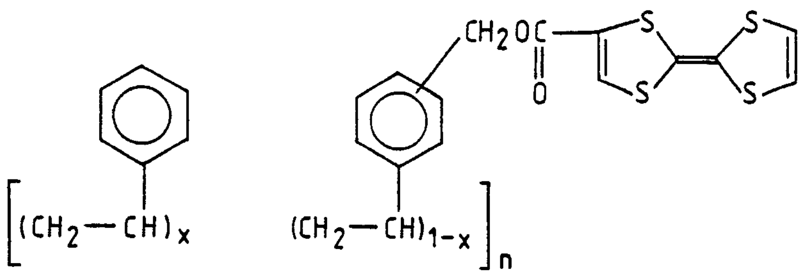

besteht, wobei der Wert von X $0 \leq X < 1$ ist und n zwischen ungefähr 50 und ungefähr 10 000 liegt,

(c) Musterbelichtens der Schicht aus negativem Photoresist mit Elektronenstrahl- oder Röntgenstrahlung;

(d) Entwickelns des negativen Photoresists zur Aufdeckung von Abschnitten des darunter liegenden auf fernes Ultraviolett empfindlichen Polymers;

(e) Belichtens der aufgedeckten Abschnitte des darunter liegenden auf fernes Ultraviolett empfindlichen Polymers mit Strahlung fernen Ultravioletts; und

(f) Entwickelns der belichteten Abschnitte des auf fernes Ultraviolett empfindlichen Polymers mit einem Vorzugslösungsmittel.

2. Verfahren nach Anspruch 1, bei welchem der halogen-substituierte Kohlenwasserstoff im negativen Photoresist aus der Gruppe, bestehend aus $CCl_4$, $CBr_4$, $CI_4$, $C_2Cl_6$, $C_2Cl_2Br_2$, $C_3Br_4H_4$, $C_2Br_2Cl_4$, $C_2H_2Cl_4$, $C_2Br_6$, $C_3Cl_8$, $CHBr_3$ und $CH_2Cl_2$, ausgewählt ist.

3. Verfahren nach Anspruch 2, bei welchem der halogen-substituierte Kohlenwasserstoff in einer Höhe von 0,01- bis 10-mal der Konzentration des Tetrathiafulvalenanteils des elektroaktiven Polymers vorhanden ist.

4. Verfahren nach irgendeinem vorstehenden Anspruch, bei welchem n in dem elektroaktiven Polymer einen mittleren Wert von ungefähr 100 hat.

5. Verfahren nach irgendeinem vorstehenden Anspruch, bei welchem das auf fernes Ultraviolett empfindliche Polymer in einer Gesamtdicke zwischen ungefähr 0,2 μm und ungefähr 10 μm aufgebracht wird.

6. Verfahren nach Anspruch 5, bei welchem das auf fernes Ultraviolett empfindliche Polymer in einer Gesamtdicke zwischen ungefähr 0,5 μm und ungefähr 3 μm aufgebracht wird.

7. Verfahren nach irgendeinem vorstehenden Anspruch, bei welchem die auf fernes Ultraviolett empfindliche Schicht aus einem Alkylmethacrylat-Polymer ist.

8. Verfahren nach Anspruch 7, bei welchem das Alkylmethacrylat-Polymer ein Polymethylmethacrylat ist.

9. Verfahren nach Anspruch 8, bei welchem das Polymethylmethacrylat ein mittleres Molekulargewicht zwischen ungefähr 30 000 und ungefähr 2 000 000 besitzt.

10. Verfahren nach Anspruch 8 oder Anspruch 9, bei welchem die Polymethylmethacrylat-Schicht durch Schleuderbeschichtung aus einer 2-Methoxyäthyläther-Lösung aufgebracht wird.

11. Verfahren nach irgendeinem vorstehenden Anspruch, bei welchem die Negativphotoresist-Schicht einer Elektronenstrahl-Strahlung für eine Ladungsdichte im Bereich von ungefähr $1 \cdot 10^{-6} C/cm^2$ und ungefähr $50 \cdot 10^{-6} C/cm^2$ ausgesetzt wird.

12. Verfahren nach irgendeinem der Ansprüche 1 bis 10, bei welchem die Negativphotoresist-Schicht einer Röntgenstrahlung für eine Dosis zwischen ungefähr 10 $mJ/cm^2$ und 100 $mJ/cm^2$ ausgesetzt wird.

13. Verfahren nach irgendeinem vorstehenden Anspruch, bei welchem das auf fernes Ultraviolett empfindliches Polymer einer Strahlung fernen Ultravioletts bei einer Ladungsdichte zwischen ungefähr 100 $mJ/cm^2$ und ungefähr 2000 $mJ/cm^2$ ausgesetzt wird.

14. Verfahren nach irgendeinem vorstehenden Anspruch, bei welchem die Negativphotoresist-Schicht mit Tetrahydrofuran oder Cyclopentanon entwickelt wird.

**Revendications**

1. Procédé pour produire une image d'une réserve comprenant les étapes successives de:

(a) dépôt sur un substrat d'un polymère sensible à l'ultraviolet moyen;

(b) dépôt sur ledit polymère sensible à l'ultraviolet moyen d'une couche d'un agent de réserve négatif comprenant un polymère polystyrène-tétrathiafulvalène électroactif, additionné d'hydrocarbure halogéne ayant le motif:

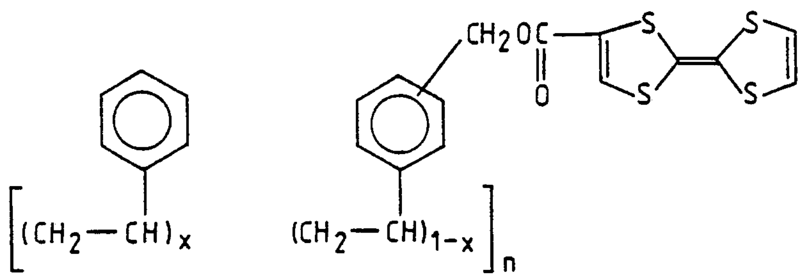

dans lequel la valeur de X est de $0 \leq X < 1$ et n va d'environ 50 à environ 10 000;

(c) exposition au motif de la couche de l'agent de réserve négatif par un rayonnement d'un faisceau d'électrons ou de rayons X;

(d) développement de l'agent de réserve négatif pour révéler des portions du polymère sensible à l'ultraviolet moyen, situé au-dessous;

(e) exposition desdites portions révélées du polymère sensible à l'ultraviolet moyen situé au-dessous, à un rayonnement ultraviolet moyen; et

(f) développement des portions exposées du polymère sensible à l'ultraviolet moyen par un solvant préférentiel.

2. Procédé selon la revendication 1, dans lequel l'hydrocarbure halogéné dans l'agent de réserve négatif est choisi dans le groupe comprenant $CCl_4$, $CBr_4$, $Cl_4$, $C_2Cl_6$, $C_2Cl_2Br_2$, $C_3Br_4H_4$, $C_2Br_2Cl_4$, $C_2H_2Cl_4$, $C_2Br_6$, $C_3Cl_8$, $CHBr_3$ et $CH_2Cl_2$.

3. Procédé selon la revendication 2, dans lequel l'hydrocarbure halogéné est présent à raison de 0,01 à 10 fois la concentration du fragment tétrathiafulvalène du polymère électroactif.

4. Procédé selon l'une quelconque des revendications précédentes, dans lequel n dans ledit polymère électroactif possède une valeur moyenne d'environ 100.

5. Procédé selon l'une quelconque des revendications précédentes, dans lequel on applique le polymère sensible à l'U.V. moyen pour une épaisseur totale allant d'environ 0,2 µm à environ 10 µm.

6. Procédé selon la revendication 5, dans lequel on applique le polymère sensible à l'UV moyen pour une épaisseur totale allant d'environ 0,5 µm à environ 3 µm.

7. Procédé selon l'une quelconque des revendications précédentes, dans lequel la couche sensible à l'UV moyen est faite d'un polymère de méthacrylate d'alkyle.

8. Procédé selon la revendication 7, dans lequel le polymère de méthacrylate d'alkyle est un poly (méthacrylate de méthyle).

9. Procédé selon la revendication 8, dans lequel le poly (méthacrylate de méthyle) possède une masse moléculaire moyenne allant d'environ 30 000 à environ 2 000 000.

10. Procédé selon la revendication 8 ou 9, dans lequel on applique la couche de poly (méthacrylate de méthyle) par dépôt centrifuge à partir d'une solution d'éther 2-méthoxyéthylique.

11. Procédé selon l'une quelconque des revendications précédentes, dans lequel la couche d'agent de réserve négatif est exposé à un rayonnement de faisceau d'électrons pour une densité de charge comprise dans l'intervalle allant d'environ $1 \times 10^{-6} C/cm^2$ à environ $50 \times 10^{-6} C/cm^2$.

12. Procédé selon l'une quelconque des revendications précédentes 1 à 10, dans lequel la couche d'agent de réserve négatif est exposée à un rayonnement de rayons X pour une dose allant d'environ 10 $mJ/cm^2$ à environ 100 $mJ/cm^2$.

13. Procédé selon l'une quelconque des revendications précédentes, dans lequel le polymère sensible à l'UV moyen est exposé à un rayonnement UV moyen à une densité de charge allant d'environ 100 $mJ/cm^2$ à environ 2000 $mJ/cm^2$.

14. Procédé selon l'une quelconque des revendications précédentes, dans lequel la couche d'agent de réserve négatif est développée avec du tétrahydrofuranne ou de la cyclopentanone.